# EUROPEAN PATENT SPECIFICATION

(11) **EP 0 685 970 B1**
(45) Date of publication and mention of the grant of the patent: **20.02.2008**
(21) Application number: 95303726.4
(22) Date of filing: 31.05.1995
(51) Int. Cl.: H04N 7/26, H03M 7/30

(54) **Variable-length decoder for bit-stuffed data**
Dekodierer variabler Länge für bitgestopfte Daten
Décodeur à longueur variable pour des données ayant des bits de bourrage

(30) Priority: 31.05.1994 KR 9412227
(43) Date of publication of application: 06.12.1995
(73) Proprietor: SAMSUNG ELECTRONICS CO., LTD., Suwon-City, Kyungki-do 441-370 (KR)
(72) Inventor: Moon, Heon-Hee, Suwon-city, Kyungki-Do (KR)
(74) Representative: Neill, Alastair William

(56) References cited:
- EP-A- 0 471 118
- EP-A- 0 498 081
- EP-A- 0 506 294
- EP-A- 0 572 766
- EP-A- 0 579 514
- EP-A- 0 597 439
- EP-A- 0 598 346
- US-A- 5 241 382
- US-A- 5 414 468

## Description

The present invention relates to a variable-length decoder, and more particularly, though not exclusively, to a variable-length decoder for variable-length-decoding variable-length-encoded and bit-stuffed data.

Generally, digital video signal encoding methods are divided into a signal source encoding method and an entropy encoding method. The signal source encoding method uses redundancy contained in a video signal to compress video data, for which a discrete cosine transform (DCT) method, a band-division encoding method and a differential pulse code modulation (DPCM) method are used. The entropy encoding method compresses further the data compressed by the signal source encoding method based on statistical occurrence frequency for which a variable-length coding (VLC) method is representatively used. The VLC method is usually composed of a run-length coding method and a (modified) Huffman coding method. Here, a pair of "run" and "level" obtained by the run-length coding method is considered as a single symbol. Accordingly, a shorter codeword is assigned to a symbol having higher occurrence frequency in the Huffman code table. On the other hand, a relatively longer codeword is assigned to the other symbol having lower occurrence frequency in the Huffman code table. Thus, the total data transmission rate is reduced. Such encoding methods are being used in a digital high-definition television (HD-TV) such as an advanced TV in U.S.A., and the Moving Picture Expert Group (MPEG) of which the standardization is pursued in the ISO/CCITT.

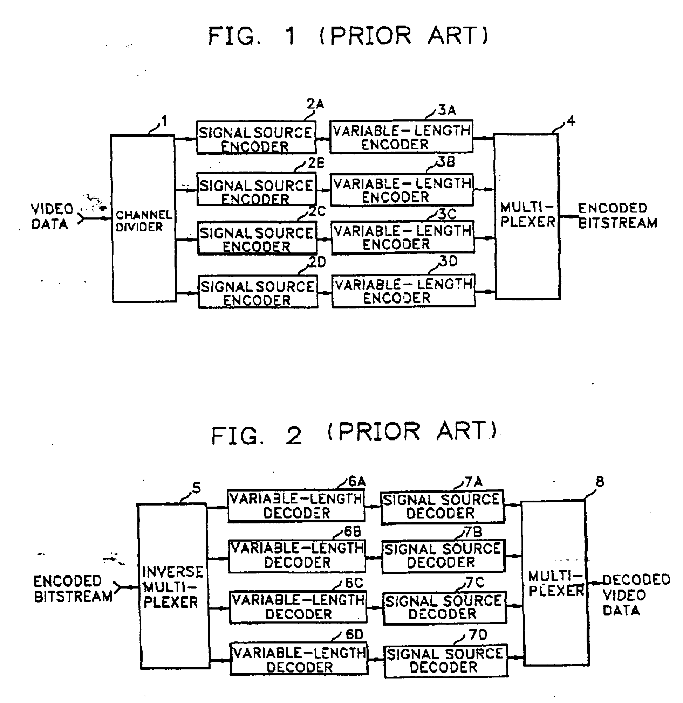

The digital HD-TV system uses a combination of the signal source encoding method and the VLC method which adopt the DCT or DPCM. Also, since an amount of the data to be processed is extremely large, a picture is divided into several windows to then be processed, of which one example will be described below with reference to Figures 1 and 2.

Figure 1 shows an encoding system for video data and Figure 2 shows a decoding system for video data. When the systems of Figures 1 and 2 are used, a picture can be divided into four windows to then be processed, thereby lowering a processing speed of video data. In the encoding system of Figure 1, input video data is divided into data of four channels by a channel divider 1, the divided channel data is compressed by each signal source encoder 2A, 2B, 2C or 2D. The video data compressed by signal source encoders 2A through 2D is further compressed by variable-length encoders 3A through 3D. The data output from variable-length encoders 3A through 3D is applied to a multiplexer 4. Multiplexer 4 multiplexes the input data to produce an encoded bitstream.

The decoding system of Figure 2 restores the bitstream produced by the Figure 1 system into the prior-to-being-encoded video data. An inverse multiplexer 5 separates the input bitstream into the data of the four channels. Each of variable-length decoders 6A through 6D variable-length-decodes the separated channel bitstream and each of signal source decoders 7A through 7D decodes the variable-length-decoded data to generate data substantially same as that of the prior-to-being-encoded video data in the corresponding channel. A multiplexer 8 multiplexes the respective window data output from signal source decoders 7A through 7D to generate decoded video data. As a result, the data output from multiplexer 8 becomes data substantially the same as that applied to channel divider 1 of Figure 1.

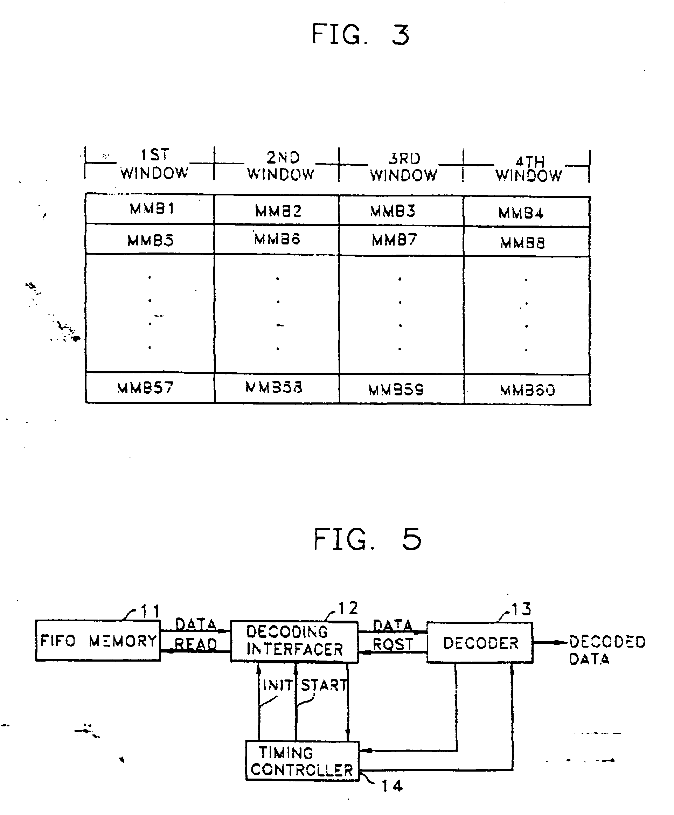

Figure 3 shows that one frame picture is divided into four windows. One window is composed of fifteen sets of a mass of macroblocks (MMBs). One MMB is composed of four slices. One slice of a plurality of macroblocks. When the system of Figure 1 uses a data structure shown in Figure 3, the system multiplexes the video data in units of the MMB. Thus, signal source encoder 2A and variable-length encoder 3A processes the MMBs in the first window, that is, MMB1, MMB5, ... and MMB57. Multiplexer 4 multiplexes the data belonging to the four windows in the order of MMB1, MMB2, MMB3, MMB4, MMB5, ... and MMB60. The system of Figure 2 separates the encoded bitstream into the video data of each window via an inverse procedure of the multiplexing process of the Figure 1 system, and variable-length-decodes and signal-source-decodes the separated video data in each window.

By the way, when the video data is transmitted from the Figure 1 system in a constant transmission rate via a buffer (not shown), an amount of the data generated by the signal source encoders and the variable-length encoders is not constant, a bit stuffing operation is performed in the variable-length-encoded data block, to solve such a problem. The bit stuffing operation stuffs bits which are not filled with video information or codes for discriminating the data blocks from each other among the bits determined with respect to data blocks, with meaningless information, for example, consecutive zeros. Thus, an actual variable-length decoder 6A, 6B, 6C or 6D receives data which is obtained by variable-length-encoding and bit-stuffing the encoded bitstream. The variable-length-decoder 6A, 6B, 6C or 6D includes a first-in-first-out (FIFO) memory and a variable-length decoder unit. The variable-length decoder unit reads out a predetermined number of bits of data from the FIFO memory to perform a variable-length decoding operation and determine whether a predetermined number of following bits of data will be read out on the basis of the number of the bits of which the variable-length-decoding operation is finished. Therefore, when the bit-stuffed bits are read out from the FIFO memory, the variable-length decoder cannot perform any variable-length decoding operation with respect to such bits. Accordingly, it becomes difficult in reading a predetermined number of the following bits and it becomes also difficult in variable-length-decoding the bits following the bit-stuffed data.

Moreover, when an error is generated in the bitstream during transmission, the variable-length decoder performs a wrong variable-length decoding operation with respect to the error-generated bits. When a degree of the error is severe, data is wrongly read from the FIFO memory, thereby wrongly decoding the bits following the error-generated bit.

The above-described problems cause sync collapse between the decoded data corresponding to the respective windows, when one picture is divided into four windows.

European patent application EP506294 (American Telephone and Telegraph Company) discloses a hierarchical variable length decoder for digital video data. In this document, there is described an arrangement for efficient decoding of a hierarchical, variable length, encoded data sequence.

In this arrangement, there is disclosed an apparatus comprising a decoder including a finite state machine and a synchronization detector. When errors occur in the encoded data sequence causing the finite state decoder means to lower context, the synchronization detector resynchronizes the finite state machine when it detects a known codeword in the sequence, resetting the finite state machine to a known state at the beginning of each frame.

It is an aim of preferred embodiments of the present invention to provide a variable-length decoding apparatus in which a frame start code and a mass of macroblock (MMB) start code are used to control a reading operation of variable-length-encoded data from a FIFO memory, and the data read from the FIFO memory by such a control is variable-length-decoded.

According to the present invention, there is provided a variable-length decoding apparatus for variable-length-decoding data transmitted in the form of a bitstream of variable length encoded image frame data, wherein the bitstream of each image frame has a constant data format comprising frame header data and data relating to masses of macroblocks,
the frame header data comprising: a frame start code (FSC); a frame number (FN); buffer status information (BSI); and frame header stuffed bits; and
the masses of macroblocks data comprising: a plurality of sequentially arranged masses of macroblocks, each of which comprises: a mass of macroblocks start code (MSC) ; a mass of macroblocks number (MN) number; Mass of Macroblocks Information; and mass of macroblock stuffed bits; and each Mass of Macroblocks Information comprising blocks; and each block comprising an End of Block (EOB) code;
wherein the frame start code (FSC), the frame number (FN) , the masses of macroblocks start code (MSC) and the masses of macroblocks number (MN) each use fixed length codes and the Mass of macroblocks Information of each Mass of macroblock uses variable length codes and the mass of macroblock stuffed bits are arranged to ensure that mass of macroblock data is always a multiple of 24-bits, said variable-length decoding apparatus comprising:
a FIFO memory, for receiving variable length encoded data and sequentially outputting said data, a decoding interfacer for receiving said data output from said FIFO memory, decoder means for variable-length-decoding the variable-length-encoded data supplied to it from the decoding interface means, and a timing controller for controlling operations of the decoding interfacer and the decoder means, the apparatus being characterised in that :
   said apparatus is controlled on the basis of a plurality of control signals comprising a read signal (READ) generated within the decoding interface means, a Request signal (RQST) generated by the decoder means, a start signal (START) generated by the timing controller,
an initialization signal (INIT) generated by the timing controller, an end of block error signal (EOB ERROR) generated by the decoder, and a signal denoting the detection of a Frame Start Code (FSC) or Mass of Macroblock Start Code (MSC) generated by the decoding interface means wherein:
   said first-in-first-out (FIFO) memory is arranged to receive and store the variable length encoded data and to sequentially output said data to the decoding interface means in data blocks of 24-bits every time said read signal (READ) is input thereto from said decoding interface means;
   said decoding interface means is arranged to:
      (i) receive 24-bit data from the FIFO memory;
      (ii) detect, if present within said received data, a frame start code (FSC) or Mass of Macroblock start code (MSC) and output the resultant detection signal to the timing controller;
      (iii) transmit variable length encoded data to the decoder means for decoding;
      (iv) wherein the generation of said READ signal is made in response to either the start signal (START) being received from the timing controller or said data request signal (RQST) being received from said decoder means whilst the initialisation signal (INIT) is applied; and
      (v) wherein generation of the read signal (READ) is interrupted if one of a frame start code (FSC) or an MMB start code (MSC) is detected in the data applied from the FIFO memory, and
      (vi) wherein the data stored in said decoding interface means is thereafter supplied to the decoder means in response to the reception of an initialization signal (INIT) from the timing controller;
   said decoder means is arranged to generate a data request signal (RQST) every time 24-bits have been decoded, or if the decoder means cannot decode the data because the decoder judges that the data to be decoded comprises stuffed bits, said decoder means being further arranged for generating the EOB error signal if EOB data of a Mass of Macroblocks is not detected correctly in every block being decoded and for transmitting said EOB error signal to said timing controller;
   said timing controller is arranged for generating said start signal (START) and said initialisation signal (INIT), wherein the start signal (START) is generated in response to receipt of said signal from the decoding interface means denoting the detection of a Frame Start Code (FSC), and the initialization signal (INIT) is generated each time a new Mass of Macroblocks Start Code is detected by said decoding interfacer, said initialization signal (INIT) being supplied at a predetermined time interval after a previous initialization signal, said timing controller being further arranged in response to the reception of said EOB error signal from the decoder means to both generate a control signal for interrupting operation of the decoder means and to generate a new start signal (START) to be supplied to the decoding interface means to cause the decoding interface means to continuously read stored data from the FIFO memory until either a next Frame Start Code (FSC) or next Mass of Macroblock Start Code (MSC) is detected, at which point synchronisation of the apparatus is restored and decoding operations can recommence.

Suitably, said decoding interface means (12) comprises:
a data latch portion of which the data input end is connected to a data output end of said FIFO memory, and of which the data output end is connected to said decoding means, for latching the data output from said FIFO memory every read signal in the input order according to a select signal; a detector for receiving the data latched to said data latch portion and the data output from said FIFO memory, detecting one between the frame start signal (FSC) and the MMB start signal (MSC), latching a first binary signal which is generated to vary the value thereof according to a detection result, and clearing the latched first binary signal if one among the start signal and the initialization signal is input from said timing controller; and a control signal generator for generating the read signal of which the value one between the first binary value for enabling to read the data from said FIFO memory and a second binary value for disabling the read of the data from said FIFO memory, and the select signal of which the value is one between a third binary value for newly latching the data supplied from said FIFO memory and a fourth binary value for maintaining the already-latched data as it is.

Suitably, said data latch portion comprises:
first and second latches for sequentially latching the data output from said FIFO memory by predetermined bits and outputting the latched data to said decoding means;
a first multiplexer for receiving the output data from said FIFO memory and said first latch and outputting the received data to said first latch according to a binary value of the select signal; and
a second multiplexer for receiving the output data from said first and second latches and outputting the received data to said second latch according to a binary value of the select signal.

Suitably, said detector comprises:
third and fourth latches of which the output values are cleared into zero respectively by the start signal and the initialization signal from said timing controller;
a first comparator for comparing the output data from said first latch with the predeterminedly set MMB start code, and outputting a first binary signal having a binary value of "1" if the data is identical to each other according to the comparison result while outputting the first binary signal having a binary value of "0" if the data is different from each other according to the comparison result;
a second comparator for comparing the data input to said first multiplexer with a part of the predeterminedly set frame start code, and outputting a second binary signal having a binary value of "1" if the data is identical to each other according to the comparison result while outputting the first binary signal having a binary value of "0" if the data is different from each other according to the comparison result;
a third multiplexer for selecting one between the output data of said third latch and said first comparator according to the select signal and outputting the selected result to said third latch;
a fourth multiplexer for selecting one between the output data of said fourth latch and said second comparator according to the select signal and outputting the selected result to said fourth latch; and
a fifth latch for latching the output data from said third latch.

Suitably, said control signal generator comprises:
an RS flip-flop for receiving the start signal from said timing controller via one input end (S) and the first binary signal from said third latch via another input end (R), and outputting the data via the output end (Q);
an AND gate for logically multiplying the data request signal from said decoding means by an inverted output data of said fifth latch;
an OR gate for logically summing the output data from said RS flip-flop and the output data from said AND gate and outputting the logically summed result;
a sixth latch for latching the output from said OR gate and outputting the latched result as the read signal applied to said FIFO memory; and
a seventh latch for latching the output data from said sixth latch and outputting the latched result as the select signal.

Suitably, said decoding interface means generates a detection resultant signal if the frame start code is detected and outputting the generated signal to said timing controller, and
wherein said timing controller outputs the start signal for the first operation of said variable-length decoding apparatus to said decoding interface means, generates a new start signal to read the data containing the MMB start code from said FIFO memory based on a detection resultant signal if the detection resultant signal is applied from said decoding interface means in response to the start signal for the first operation, and outputs the generated new start signal to said decoding interface means.

Preferred embodiments of the present invention are described, by way of example only, with reference to the drawings wherein:
Figure 1 is a block diagram of a general video signal encoding system.
Figure 2 is a block diagram of a general video signal decoding system.
Figure 3 is a view for explaining an example of a processing unit of video data according to the present invention.
Figures 4A and 4B are views showing an example of a bitstream proposed in the present invention to decode bit-stuffed bitstream.
Figure 5 is a block diagram of a variable-length decoding apparatus according to a preferred embodiment of the present invention.
Figure 6 is a circuit diagram showing an example of the detailed construction of the decoding interface of Figure 5.

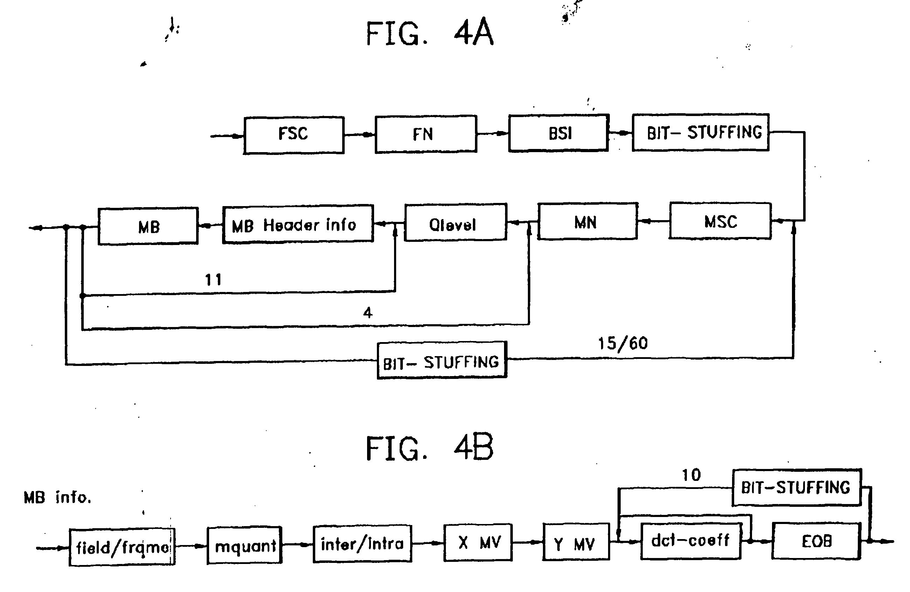

A preferred embodiment of the present invention will be described below in more detail with reference to the accompanying drawings Figures 4A through 6.

Figures 4A and 4B show a structure of a bitstream used in a preferred embodiment of the present invention. Figure 4A shows a structure of a bitstream belonging to one frame. The bitstream of Figure 4A is constructed to be adapted in a case where a FIFO memory for a variable-length-decoding operation outputs 24-bit data basically. It is apparent that a number of modifications are possible within the scope of the present invention for performing a variable-length-decoding operation with respect to the number of bits different from the 24 bits. The bitstream of Figure 4A can be a structure of the bitstream corresponding to each window which is separated by inverse multiplexer 5, or that corresponding to one frame prior to being separated. The one-frame bitstream includes frame head data comprising a frame start code (FSC), a frame number (FN), buffer status information (BSI) and stuffed bits. In a preferred embodiment of the present invention, the number of bits of the FSC is 32, that of the FN is 4, that of the BSI is 20 and that of the stuffed bits are 16. Fifteen or sixty MMBs are located at the rear end of the stuffed bits. One frame is composed of sixty MMBs. If one frame is divided into four windows, fifteen MMBs are contained in each window every frame. Each MMB is composed of MMB head data having a 24-bit MMB start code (MSC) and an 8-bit MMB number (MN) and the stuffed bits. Four q-levels, eleven macroblock, head information and macroblock data are located between the MN and the stuffed bits. The macroblock head information includes field/frame information, a macroblock q-level (mquant), inter/intra information, a horizontal motion vector (X-MV) and a vertical motion vector (Y-MB). Each block also includes a DCT coefficient (dct_coeff) and an end-of-block (EOB) representing the end of the block. Here, the FSC, the frame number the MSC and the MMB number (or the MMB address) use a fixed-length code, respectively. Since the number of bits of the other codes is varied as is the case, a bit of "0" for bit-stuffing is added by the insufficient number of bits when the MMB data does not become a multiple of 24 bits.

Figure 5 is a block diagram of a variable-length decoding apparatus according to a preferred embodiment of the present invention. The Figure 5 apparatus variable-length-decodes input data based on a basic data format with respect to bit-stuffed data after being variable-length-encoded. In Figure 5, a FIFO memory 11 stores bitstream corresponding to one window described in relation to Figures 4A and 4B. Whenever a read signal is input, 24-bit data starting from firstly stored bits is output to a decoding interfacer 12. The decoding interfacer 12 detects an FSC or an MSC from the data read from FIFO memory 11 to output the detection resultant signal to a timing controller 14. The decoding interfacer 12 transmits also the data read out from FIFO memory 11 to decoding unit 13. Decoding unit 13 variable-length-decodes the data supplied from decoding interfacer 12 and generates a data request signal RQST to be supplied to decoding interfacer 12. Decoding unit 13 generates also an EOB error signal according to detection of an EOB signal representing the end of each block, and supplies the generated EOB error signal to timing controller 14. Timing controller 14 generates an initialization signal (INIT) and a start signal to be supplied to decoding interfacer 12, and generates a control signal necessary for a variable-length-decoding operation to be supplied to decoding unit 13.

The operation of the Figure 5 apparatus having the above-described construction will be described below.

When the Figure 5 apparatus operates for the first time, timing controller 14 generates that start signal so as to start to process the one-frame data, and supplies the generated start signal to decoding interfacer 12. Decoding interfacer 12 generates the read signal in response to the start signal to output the same to FIFO memory 11. FIFO memory 11 receives the data corresponding to one window among four windows constituting one frame in the form of bitstream and stores the received data, and outputs 24-bit data to decoding interfacer 12 starting from the firstly stored data whenever the read signal is applied thereto. Decoding interfacer 12 latches the data read from FIFO memory 11 every 72-bit data, and uses the latched data to detect the FSC. When the FSC is detected, decoding interfacer 12 outputs the detection resultant signal to timing controller 14. When the detection resultant signal is applied thereto, timing controller 14 generates a new start signal. The new start signal is used for reading the data following the 72-bit data latched by decoding interfacer 12. Timing controller 14 generates also a signal for controlling a data decoding operation for data which is supplied from FIFO memory 11 to decoding unit 13 to supply the generated signal to decoding unit 13. Decoding interfacer 12 reads data from FIFO memory 11 in response to the new start signal and detects an MSC using the read data. The detection resultant signal according to the detection of the MSC is supplied to timing controller 14. Timing controller 14 generates an initialization signal INIT in response to the detection resultant signal. The initialization signal INIT is generated in timing controller 14 at the previous point of time from the point of time when the respectively variable-length encoded data of the MMBs is read from FIFO memory 11. Decoding interfacer 12 reads data from FIFO memory 11 according to data request signal RQST which is applied from decoding unit 13 if the initialization signal is applied. Decoding unit 13 variable-length-decodes the data supplied from decoding interfacer 12 using an internal decoding table, and generates the data request signal RQST if the number of the data used for decoding becomes a predetermined number of bits. When new data from FIFO memory 11 is input through decoding interfacer 12 according to the data request signal RQST, decoding unit 13 variable-length-decodes the input data. When the input data cannot be decoded with the internal decoding table during the decoding operation, decoding unit 13 judges that the input data is bit-stuffed data, to then continuously generate data request signal RQST. In more detail, decoding unit 13 generates data request signal RQST if a sum of the number of the data used for variable-length-decoding and the number of the bit-stuffed data, or the number of the bit-stuffed data becomes the number of the bits for generating data request signal RQST in decoding unit 13. The generated data request signal RQST is output to decoding interfacer 12. In a preferred embodiment of the present invention, the number of the bits for generating data request signal RQST is twenty-four being the number of bits which is read from FIFO memory 11 in a given time. Through such a procedure, the bit-stuffed bits are removed, and are additionally inserted into the rear end of the variable-length-encoded data.

On the other hand, if the data request signal RQST is generated in decoding unit 13 for removing the bit-stuffed bits, decoding interfacer 12 generates a read signal in response to data request signal RQST, and detects the MSC using the data supplied from FIFO memory 11. If the MSC is detected, decoding interfacer 12 stops generation of the read signal and generates a detection resultant signal to supply the generated signal to timing controller 14. Timing controller 14 generates the initialization signal INIT for the following MMB. A point of time of generating the initialization signal INIT is determined based on a point of time of detecting an initially detected FSC, a point of time of detecting the FSC of the previous frame, or a point of time of detecting the MSC of the previous MMB in the Figure 5 apparatus. After the initialization signal INIT is applied from timing controller 14, decoding interfacer 12 generates the read signal in response to data request signal RQST from decoding unit 13. FIFO memory 11 outputs the stored data in response to the read signal to decoding interfacer 12. Decoding interfacer 12 detects the MSC using the data supplied from FIFO memory 11 by the read signal. If the MSC is detected, decoding interfacer 12 outputs the detection resultant signal to timing controller 14 and simultaneously holds the stored data continuously. Decoding interfacer 12 no longer generates the read signal as well. Thus, the variable-length-encoded data in the MMB containing the detected MSC is not applied to decoding unit 13. If timing controller 14 generates a new initialization signal INIT, decoding interfacer 12 reads data from FIFO memory 11 in response to data request signal RQST from decoding unit 13 and supplies the read data to decoding unit 13. From the following operation, a variable-length-decoding operation is performed with respect to fifteen MMBs of one frame through the above-described procedure.

If data is continuously applied from FIFO memory 11 according to the data request signal RQST for reading the bit-stuffed bits filled in the fifteenth MMB, decoding interfacer 12 detects the FSC using the applied data. On the other hand, timing controller 14 generates a new start signal of a frame interval based on the point of time of detecting the previously detected FSC. The start signal is generated at the very previous time when frame head data of a new frame is applied to decoding interfacer 12. Decoding interfacer 12 generates a read signal in response to the start signal. FIFO memory 11 outputs the stored data to decoding interfacer 12 in response to the read signal. If the FSC is detected from the data supplied from FIFO memory 11, decoding interfacer 12 does not generate the read signal any longer and holds the data supplied from FIFO memory 11 as it is. When the FSC is detected, decoding interfacer 12 latches the first MSC in the frame. Thus, decoding interfacer 12 detects the FSC and MSC with respect to the start signal generated every frame except for the initial operation. If the initialization signal INIT is applied from timing controller 14, decoding interfacer 12 performs an operation in which the data from FIFO memory 11 is supplied to decoding unit 13 in response to the data request signal RQST.

On the other hand, during the time when a variable-length-decoding operation is proceeded by the Figure 5 apparatus, decoding unit 13 judges whether EOB data representing the end of every block exists. If the EOB data is not obtained by the decoding operation, decoding unit 13 generates an EOB error signal to supply it to timing controller 14. Decoding unit 13 generates also the data request signal RQST for reading the data of the error-generated MMB. If the EOB error signal is applied, timing controller 14 generates a control signal for interrupting an operation of decoding unit 13 until the detection resultant signal is not applied from decoding interfacer 12. Timing controller 14 generates also a new start signal to output it to decoding interfacer 12. Decoding unit 13 does not decode the data input from decoding interfacer 12 on the basis of the control of timing controller 14. Decoding interfacer 12 continuously reads the stored data from FIFO memory 11 in response to the start signal and detects whether the FSC or MSC exists. Thereafter, in the Figure 5 apparatus, decoding interfacer 12 reads again the data from FIFO memory 11, and performs an operation again between the detection procedure of the FSC or MSC from the read data and the generation procedure of the initialization signal INIT according to the code detection. Thus, when an error is generated in the bitstream, residue data is read until the following MMB data shows up, thereby reconstructing the lost synchronization. Since the following operation is the same as that of normally performing a decoding operation in the Figure 5 apparatus as described above, the detailed description will be omitted.

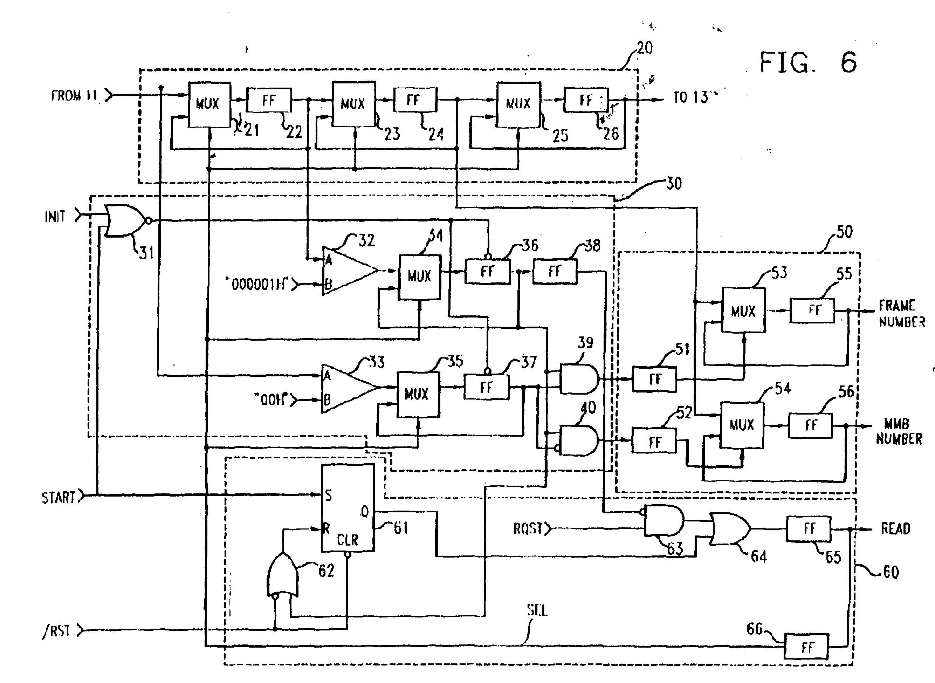

Figure 6 is a circuit diagram showing an example of the detailed construction of the decoding interfacer 12 of Figure 5. The FSC used in the Figure 6 apparatus is a hexadecimal value of "00000100H" and the MSC is a hexadecimal value of "000001H". The construction and operation of the Figure 6 apparatus will be described below.

Decoding interfacer 12 comprises a data latch portion 20, an FSC/MSC detector 30, a number output portion 50 and a control signal generator 60. If a high-level pulse start signal or an initialization signal INIT from timing controller 14 is applied to FSC/MSC detector 30 and control signal generator 60, flip-flops 36 and 37 in FSC/MSC detector 30 are cleared by the low-level pulse applied to the reset end via a NOR gate 31, so that the output values are zero. RS flip-flop 61 in control signal generator 60 is cleared by a reset signal /RST and outputs a binary value of "1" via the output end Q in response to the start signal applied to one end S. A flip-flop 65 latches a binary value of "1" applied from RS flip-flop 61 via an OR gate 64. The binary signal latched to flip-flop 65 is output to FIFO memory 11 and flip-flop 66. The binary value of "1" output from flip-flop 65 is used as a read signal for FIFO memory 11. The output of flip-flop 66 is used as a select signal SEL for controlling multiplexers 21, 23, 25, 34 and 35. In data latch portion 20, flip-flops 22, 24 and 26 sequentially latch the data output from FIFO memory 11 by predetermined bits in response to the read signal from control signal generator 60. The data latched in flip-flop 26 is supplied to decoding unit 13. Multiplexer 21 receives the output data from FIFO memory 11 and flip-flop 22, and selects one therebetween according to a binary value of the select signal output from control signal generator 60 to supply the selected one to flip-flop 22. Multiplexer 23 receives the output data from flip-flop 22 and flip-flop 24, and selects one therebetween according to a binary value of the select signal to supply the selected one to flip-flop 24. Likewise, multiplexer 25 receives the output data from flip-flop 24 and flip-flop 26, and selects one therebetween according to a binary value of the select signal to supply the selected one to decoding unit 13. On the other hand, a comparator 32 in FSC/MSC detector 30 compares the output data from flip-flop 22 with the MSC of "000001H". Comparator 32 outputs a binary value of "1" if the data values are the same as each other by the comparison result, while the former outputs a first binary signal having a binary value of "0" if the latter is not different from each other. Multiplexer 34 selects one between the output data of comparator 32 and flip-flop 36 according to the select signal from control signal generator 60 and outputs the selected one to flip-flop 36. The output data from flip-flop 36 is output to flip-flop 38 and control signal generator 60. A comparator 33 compares the data applied to flip-flop 21 with a part of the FSC of "00H". Comparator 33 outputs a binary value of "1" if the data values are the same as each other by the comparison result, while the former outputs a second binary signal having a binary value of "0" if the latter is not different from each other. Multiplexer 35 selects one between the output data of comparator 33 and flip-flop 37 according to the select signal and outputs the selected one to flip-flop 37. The output data from flip-flop 37 is supplied to the inputs of AND gates 39 and 40. AND gate 39 logically multiplies the output data of flip-flops 36 and 37 and supplies the result to number output portion 50. AND gate 40 logically multiplies the inverted output data of flip-flop 36 and the output data from flip-flop 37 and supplies the result to number output portion 50.

On the other hand, RS flip-flop 61 in control signal generator 60 outputs a binary signal of "0" via output end Q in response to a first binary signal, if flip-flop 36 outputs the first binary signal having the value of "1" according to the FSC or MSC detection. AND gate 63 logically multiplies the data request signal RQST from decoding unit 13 by the inverted output data of flip-flop 38, and outputs the result. OR gate 64 logically sums the output data of RS flip-flop 61 and AND gate 63 and outputs the result. Flip-flop 65 latches the output from OR gate 64. The data output from flip-flop 65 is used as a read signal applied to FIFO memory 11. Flip-flop 66 latches the output data from flip-flop 65. The output data from flip-flop 66 is used as select signals SEL for multiplexers 21, 23, 25, 34 and 35.

Number output portion 50 comprises flip-flops 55 and 56 for latching the data applied from flip-flop 24. Multiplexer 53 selects one between the data from flip-flops 55 and 24 according to the output data from AND gate 39 latched in flip-flop 51 and outputs the result to flip-flop 55. Also, multiplexer 54 selects one between the data from flip-flops 56 and 24 according to the output data from AND gate 40 latched in flip-flop 52 and outputs the result to flip-flop 56. Flip-flop 55 latches the frame number and flip-flop 56 latches the MMB number, according to the data selection of multiplexers 53 and 54.

Since it is obvious to a person skilled in the art with respect to the above-described Figure 6 apparatus; thus, the detailed descriptions of the start signal and initialization signal will be omitted. It will be appreciated that the person having ordinary skill can see the Figure 6 apparatus sufficiently based on the Figure 5 apparatus.

As described above, the variable-length-decoding apparatus for the bit-stuffed data according to the present invention synchronizes the data supplied to the decoding unit based on the detection of the FSC and MSC. Thus, although the bit-stuffing is performed on the bitstream, or the error is generated, the MMB following the error-generated MMB can be accurately decoded. As well, when the video frame is processed by dividing the video frame into a plurality of windows, and an amount of the bit-stuffed data is different from each other with respect to the respective windows, the present invention can bring an effect that the synchronization between the windows can be accurately matched.

## Claims

1. A variable-length decoding apparatus for variable-length-decoding data transmitted in the form of a bitstream of variable length encoded image frame data, wherein the bitstream of each image frame has a constant data format comprising frame header data and data relating to masses of macroblocks,
the frame header data comprising: a frame start code (FSC); a frame number (FN); buffer status information (BSI); and frame header stuffed bits; and
the masses of macroblocks data comprising: a plurality of sequentially arranged masses of macroblocks, each of which comprises: a mass of macroblocks start code (MSC) ; a mass of macroblocks number (MN) number; Mass of Macroblocks Information; and mass of macroblock stuffed bits; and each Mass of Macroblocks Information comprising blocks; and each block comprising an End of Block (EOB) code;
wherein the frame start code (FSC), the frame number (FN) , the masses of macroblocks start code (MSC) and the masses of macroblocks number (MN) each use fixed length codes and the Mass of macroblocks Information of each Mass of macroblock uses variable length codes and the mass of macroblock stuffed bits are arranged to ensure that mass of macroblock data is always a multiple of 24-bits, said variable-length decoding apparatus comprising:
a FIFO memory (11), for receiving variable length encoded data and sequentially outputting said data, a decoding interfacer (12) for receiving said data output from said FIFO memory (11), decoder means (13) for variable-length-decoding the variable-length-encoded data supplied to it from the decoding interface means (12), and a timing controller (14) for controlling operations of the decoding interfacer (12) and the decoder means (13) , the apparatus being **characterised in that** :
said apparatus is controlled on the basis of a plurality of control signals comprising a read signal (READ) generated within the decoding interface means (12), a Request signal (RQST) generated by the decoder means (13), a start signal (START) generated by the timing controller (14), an initialization signal (INIT) generated by the timing controller (14), an end of block error signal (EOB ERROR) generated by the decoder (13), and a signal denoting the detection of a Frame Start Code (FSC) or Mass of Macroblock Start Code (MSC) generated by the decoding interface means (12) wherein:
said first-in-first-out (FIFO) memory (11) is arranged to receive and store the variable length encoded data and to sequentially output said data to the decoding interface means (12) in data blocks of 24-bits every time said read signal (READ) is input thereto from said decoding interface means (12);
said decoding interface means (12) is arranged to:
(i) receive 24-bit data from the FIFO memory (11);
(ii) detect, if present within said received data, a frame start code (FSC) or Mass of Macroblock start code (MSC) and output the resultant detection signal to the timing controller (14);
(iii) transmit variable length encoded data to the decoder means (13) for decoding;
(iv) wherein the generation of said READ signal is made in response to either the start signal (START) being received from the timing controller (14) or said data request signal (RQST) being received from said decoder means (13) whilst the initialisation signal (INIT) is applied; and
(v) wherein generation of the read signal (READ) is interrupted if one of a frame start code (FSC) or an MMB start code (MSC) is detected in the data applied from the FIFO memory (11), and
(vi) wherein the data stored in said decoding interface means is thereafter supplied to the decoder means (13) in response to the reception of an initialization signal (INIT) from the timing controller (14);
said decoder means (13) is arranged to generate a data request signal (RQST) every time 24-bits have been decoded, or if the decoder means (13) cannot decode the data because the decoder judges that the data to be decoded comprises stuffed bits, said decoder means (13) being further arranged for generating the EOB error signal if EOB data of a Mass of Macroblocks is not detected correctly in every block being decoded and for transmitting said EOB error signal to said timing controller (14);
said timing controller (14) is arranged for generating said start signal (START) and said initialisation signal (INIT), wherein the start signal (START) is generated in response to receipt of said signal from the decoding interface means (12) denoting the detection of a Frame Start Code (FSC), and the initialization signal (INIT) is generated each time a new Mass of Macroblocks Start Code is detected by said decoding interfacer (12), said initialization signal (INIT) being supplied at a predetermined time interval after a previous initialization signal, said timing controller (14) being further arranged in response to the reception of said EOB error signal from the decoder means (13) to both generate a control signal for interrupting operation of the decoder means (12) and to generate a new start signal (START) to be supplied to the decoding interface means (13) to cause the decoding interface means to continuously read stored data from the FIFO memory (12) until either a next Frame Start Code (FSC) or next Mass of Macroblock Start Code (MSC) is detected, at which point synchronisation of the apparatus is restored and decoding operations can recommence.

2. The variable-length decoding apparatus of claim 1, wherein said decoding interface means (12) comprises: a data latch portion (20) of which the data input end is connected to a data output end of said FIFO memory (11), and of which the data output end is connected to said decoding means (13), for latching the data output from said FIFO memory (11) every read signal in the input order according to a select signal; a detector (30) for receiving the data latched to said data latch portion (20) and the data output from said FIFO memory (11), detecting one between the frame start signal (FSC) and the MMB start signal (MSC), latching a first binary signal which is generated to vary the value thereof according to a detection result, and clearing the latched first binary signal if one among the start signal and the initialization signal is input from said timing controller (14); and a control signal generator (60) for generating the read signal of which the value one between the first binary value for enabling to read the data from said FIFO memory (11) and a second binary value for disabling the read of the data from said FIFO memory (11), and the select signal of which the value is one between a third binary value for newly latching the data supplied from said FIFO memory (11) and a fourth binary value for maintaining the already-latched data as it is.

3. A variable-length decoding apparatus according to claim 2, wherein said data latch portion (20) comprises:
first and second latches (22, 24) for sequentially latching the data output from said FIFO memory (11) and outputting the latched data to said decoding means (13);
a first multiplexer (21) for receiving the output data from said FIFO memory (11) and said first latch (22) and outputting the received data to said first latch (22) according to a binary value of the select signal; and
a second multiplexer (23) for receiving the output data from said first and second latches (22, 24) and outputting the received data to said second latch (24) according to a binary value of the select signal.

4. A variable-length decoding apparatus according to claim 3, wherein said detector (30) comprises:
third and fourth latches (36, 37) of which the output values are cleared into zero respectively by the start signal and the initialization signal from said timing controller (14);
a first comparator (32) for comparing the output data from said first latch (36) with the predeterminedly set MMB start code, and outputting a first binary signal having a binary value of "1" if the data is identical to each other according to the comparison result while outputting the first binary signal having a binary value of "0" if the data is different from each other according to the comparison result;
a second comparator (33) for comparing the data input to said first multiplexer (21) with a part of the predeterminedly set frame start code, and outputting a second binary signal having a binary value of "1" if the data is identical to each other according to the comparison result while outputting the first binary signal having a binary value of "0" if the data is different from each other according to the comparison result;
a third multiplexer (34) for selecting one between the output data of said third latch (36) and said first comparator (32) according to the select signal and outputting the selected result to said third latch (36);
a fourth multiplexer (35) for selecting one between the output data of said fourth latch (37) and said second comparator (33) according to the select signal and outputting the selected result to said fourth latch (37); and
a fifth latch (38) for latching the output data from said third latch (36).

5. A variable-length decoding apparatus according to any one of claims 1 to 4, wherein said control signal generator (60) comprises:
an RS flip-flop (61) for receiving the start signal from said timing controller (14) via one input end (S) and the first binary signal from said third latch (36) via another input end (R), and outputting the data via the output end (Q);
an AND gate (63) for logically multiplying the data request signal from said decoding means (13) by an inverted output data of said fifth latch (38);
an OR gate (64) for logically summing the output data from said RS flip-flop (61) and the output data from said AND gate (63) and outputting the logically summed result;
a sixth latch (65) for latching the output from said OR gate (64) and outputting the latched result as the read signal applied to said FIFO memory (11); and
a seventh latch (66) for latching the output data from said sixth latch (65) and outputting the latched result as the select signal.

6. A variable-length decoding apparatus according to claim 1, wherein said decoding interface means (12) generates a detection resultant signal if the frame start code is detected and outputting the generated signal to said timing controller (14), and
wherein said timing controller (14) outputs the start signal for the first operation of said variable-length decoding apparatus to said decoding interface means (12), generates a new start signal to read the data containing the MMB start code from said FIFO memory (11) based on a detection resultant signal if the detection resultant signal is applied from said decoding interface means (12) in response to the start signal for the first operation, and outputs the generated new start signal to said decoding interface means (12).

## Patentansprüche

1. Vorrichtung zum Decodieren mit variabler Länge, die Daten, die in Form eines Bitstroms mit variabler Länge codierter Bild-Frame-Daten gesendet werden, mit variabler Länge decodiert, wobei der Bitstrom jedes Bild-Frame ein konstantes Datenformat hat, das Frame-Header-Daten und Daten umfasst, die sich auf Massen von Makroblöcken beziehen,
die Frame-Header-Daten umfassen: eine Frame-Anfangscode (frame start code - FSC), eine Frame-Nummer (frame number - FN). Pufferstatus-Informationen (buffer status information - BSI) und Frame-Header-Stopfbits; und
die Daten der Massen von Makroblöcken umfassen: eine Vielzahl sequenziell angeordneter Massen von Makroblöcken, von denen jede umfasst: einen Anfangscode einer Masse von Makroblöcken (MSC); eine Nummer der Masse von Makroblöcken (MN); Informationen der Masse von Makroblöcken; und Stopfbits der Masse von Makroblöcken, und wobei jede der Informationen der Masse von Makroblöcken Blöcke umfasst und jeder Block einen End-of-Block (EOB)-Code umfasst;
wobei der Frame-Anfangscode (FSC), die Frame-Nummer (FN), der Anfangscode der Massen von Makroblöcken (MSC) und die Nummer der Massen von Makroblöcken (MN) jeweils Codes fester Länge verwenden und die Informationen der Masse von Makroblöcken jeder Masse von Makroblöcken Codes variabler Länge verwendet und die Stopfbits der Masse von Makroblöcken so angeordnet sind, dass sie gewährleisten, dass die Daten der Masse von Makroblöcken stets ein Vielfaches von 24 Bits ist, wobei die Vorrichtung zum Decodieren mit variabler Länge umfasst:
einen FIFO-Speicher (11), der mit variabler Länge codierte Daten empfängt und die Daten sequentiell ausgibt, eine Decodier-Schnittstelleneinrichtung (12), die die von dem FIFO-Speicher (11) ausgegebenen Daten empfängt, eine Decodiereinrichtung (13), die die mit variabler Länge codierten Daten, die ihr von der Decodier-Schnittstelleneinrichtung (12) zugeführt werden, mit variabler Länge decodiert, und eine Zeit-Steuereinheit (14), die Operationen der Decodier-Schnittstelleneinrichtung (12) und der Decodiereinrichtung (13) steuert, wobei die Vorrichtung **dadurch gekennzeichnet ist, dass**
die Vorrichtung auf Basis einer Vielzahl von Steuersignalen gesteuert wird, die ein Lesesignal (READ), das in der Decodier-Schnittstelleneinrichtung (12) erzeugt wird, ein Anforderungs-Signal (RQST), das durch die Decodiereinrichtung (13) erzeugt wird, ein Anfangs-Signal (START), das durch die Zeit-Steuereinheit (14) erzeugt wird, ein Initialisierungs-Signal (INIT), das durch die Zeit-Steuereinheit (14) erzeugt wird, ein End-of-Block-Fehler-Signal (EOB ERROR), das durch die Decodiereinrichtung (13) erzeugt wird, und ein Signal umfassen, das die Erfassung eines Frame-Anfangscodes (FSC) oder eines Anfangscodes einer Masse von Makroblöcken (MSC) bezeichnet und durch die Decodier-Schnittstelleneinrichtung (12) erzeugt wird, wobei
der FIFO-Speicher (11) so eingerichtet ist, dass er die mit variabler Länge codierten Daten empfängt und speichert und die Daten sequentiell an die Decodier-Schnittstelleneinrichtung (12) in Datenblöcken von 24 Bits immer dann ausgibt, wenn das Lese-Signal (READ) von der Decodier-Schnittstelleneinrichtung (12) in ihn eingegeben wird;
die Decodier-Schnittstelleneinrichtung (12) so eingerichtet ist, dass sie:
(i) 24-Bit-Daten von dem FIFO-Speicher (11) empfängt;
(ii) einen Frame-Anfangscode (FSC) oder einen Anfangscode einer Masse von Makroblöcken (MSC) erfasst, wenn diese in den empfangenen Daten vorhanden sind, und das resultierende Erfassungssignal an die Zeit-Steuereinheit ausgibt;
(iii) mit variabler Länge codierte Daten zum Decodieren zu der Decodiereinrichtung (13) sendet;
(iv) wobei die Erzeugung des Lese-Signals in Reaktion entweder darauf, dass das Anfangs-Signal (START) von der Zeit-Steuereinheit (14) empfangen wird, oder das Datenanforderungs-Signal (RQST) von der Decodiereinrichtung (13) empfangen wird, während das Initialisierungs-Signal (INIT) angelegt wird, durchgeführt wird; und
(v) wobei Erzeugung des Lese-Signals (READ) unterbrochen wird, wenn ein Frame-Anfangscode (FSC) oder ein MMB-Anfangscode (MSC) in den von dem FIFO-Speicher (11) angelegten Daten erfasst wird, und
(vi) wobei die in der Decodier-Schnittstelleneinrichtung gespeicherten Daten anschließend in Reaktion auf den Empfang eines Initialisierungs-Signals (INIT) von der Zeitsteuereinrichtung (14) der Decodiereinrichtung (13) zugeführt werden;
die Decodiereinrichtung (13) so eingerichtet ist, dass sie ein Datenanforderungs-Signal (RQST) immer dann empfängt, wenn 24 Bits decodiert worden sind, oder, wenn die Decodiereinrichtung (13) die Daten nicht decodieren kann, da die Decodiereinrichtung feststellt, dass die zu decodierenden Daten Stopfbits umfassen, und die Decodiereinrichtung (13) des Weiteren so eingerichtet ist, dass sie das EOB-Fehler-Signal erzeugt, wenn EOB-Daten einer Masse von Makroblöcken nicht korrekt in jedem Block erfasst werden, der decodiert wird, und das EOB-Fehter-Signal zu der Zeit-Steuereinrichtung (14) sendet;
die Zeit-Steuereinheit (14) so eingerichtet ist, dass sie das Anfangs-Signal (START) und das Initialisierungs-Signal (INIT) erzeugt, wobei das Anfangs-Signal (START) in Reaktion auf Empfang des Signals von der Decodier-Schnittstelleneinrichtung (12) erzeugt wird, das die Erfassung eines Frame-Anfangscodes (FSC) angibt, und das Initialisierungs-Signal (INIT) immer dann erzeugt wird, wenn ein neuer Anfangscode einer Masse von Makroblöcken durch die Decodier-Schnittstelleneinrichtung (12) erfasst wird, das Initialisierungs-Signal (INIT) in einem vorgegebenen Zeitintervall nach einem vorangehenden Initialisierungssignal zugeführt wird, die Zeit-Steuereinheit (14) des Weiteren so eingerichtet ist, dass sie in Reaktion auf den Empfang des EOB-Fehler-Signals von der Decodiereinrichtung (13) sowohl ein Steuersignal zum Unterbrechen von Operation der Decodiereinrichtung (12) erzeugt, als auch ein neues Anfangs-Signal (START) erzeugt, das der Decodier-Schnittstelleneinrichtung (13) zuzuführen ist, um die Decodier-Schnittstelleneinrichtung zu veranlassen, kontinuierlich gespeicherte Daten aus dem FIFO-Speicher (12) zu lesen, bis entweder ein nächster Frame-Anfangscode (FSC) oder ein nächster Anfangscode einer Masse von Makroblöcken (MSC) erfasst wird, wobei an diesem Punkt Synchronisation der Vorrichtung wiederhergestellt ist und Decodieroperationen erneut beginnen können.

2. Vorrichtung zum Decodieren mit variabler Länge nach Anspruch 1. wobei die Decodier-Schnittstelleneinrichtung (12) umfasst: einen Daten-Auffangspeicherabschnitt (20), dessen Daten-Eingabeende mit einem Daten-Ausgabeende des FIFO-Speichers (11) verbunden ist und dessen Daten-Ausgabeende mit der Decodiereinrichtung (13) verbunden ist, zum Auffangspeichern der von dem FIFO-Speicher (11) ausgegebenen Daten bei jedem Lesesignal in der Eingabe-Reihenfolge gemäß einem Auswählsignal; einen Detektor (30), der die Auffangspeicherung in dem Daten-Auffangspeicherabschnitt (20) unterzogenen Daten und die von dem FIFO-Speicher (11) ausgegebenen Daten empfängt, das Frame-Anfangs-Signal (FSC) oder das MMB-Anfangs-Signal (MSC) erfasst. Auffangspeichern des ersten Binärsignals durchführt, das erzeugt wird, um den Wert desselben gemäß einem Erfassungsergebnis zu ändern, und das Auffangspeichern unterzogene erste Binärsignal löscht, wenn das Anfangs-Signal oder das Initialisierungs-Signal von der Zeit-Steuereinheit (14) eingegeben wird, und eine Steuersignal-Erzeugungseinrichtung (60) zum Erzeugen des Lese-Signals, dessen Wert der erste Binärwert zum Freigeben von Lesen der Daten aus dem FIFO-Speicher (11) oder ein zweiter Binärwert zum Verhindern des Lesens der Daten aus dem FIFO-Speicher (11) ist, und des Auswählsignals, dessen Wert ein dritter Binärwert zum erneuten Auffangspeichern der von dem FIFO-Speicher (11) zugeführten Daten oder ein vierter Binärwert zum unveränderten Beibehalten der bereits Auffangspeicherung unterzogenen Daten ist.

3. Vorrichtung zum Decodieren mit variabler Länge nach Anspruch 2, wobei der Daten-Auffangspeicherabschnitt (20) umfasst:
einen ersten und einen zweiten Auffangspeicher (22, 24) zum sequentiellen Auffangspeichern der von dem FIFO-Speicher (11) ausgegebenen Daten und zum Ausgeben der Auffangspeichern unterzogenen Daten an die Decodiereinrichtung (13);
einen ersten Multiplexer (21), der die von dem FIFO-Speicher (11) und dem ersten Auffangspeicher (22) ausgegebenen Daten empfängt und die empfangenen Daten gemäß einem Binärwert des Auswählsignals an den ersten Auffangspeicher (22) ausgibt; und
einen zweiten Multiplexer (23), der die von dem ersten und dem zweiten Auffangspeicher (22, 24) ausgegebenen Daten empfängt und die empfangenen Daten gemäß einem Binärwert des Auswähisignals an den zweiten Auffangspeicher (24) ausgibt.

4. Vorrichtung zum Decodieren mit variabler Länge nach Anspruch 3, wobei der Detektor (30) umfasst:
einen dritten und einen vierten Auffangspeicher (36, 37), deren Ausgabewerte durch das Anfangs-Signal bzw. des Initialisierungs-Signals von der Zeit-Steuereinheit (14) auf Null gelöscht werden;
eine erste Vergleichseinrichtung (32), die die von dem ersten Auffangspeicher (36) ausgegebenen Daten mit dem, wie vorgegeben eingestellten MMB-Anfangscode vergleicht und ein erstes Binärsignal mit einem Binärwert "1" ausgibt, wenn die Daten gemäß dem Vergleichsergebnis miteinander identisch sind, während sie das erste Binärsignal mit einem Binärwert "0" ausgibt, wenn sich die Daten gemäß dem Vergleichsergebnis voneinander unterscheiden;
eine zweite Vergleichseinrichtung (33), die die in den ersten Multiplexer (21) eingegebenen Daten mit einem Teil des wie vorgegeben eingestellten Frame-AnfangsCodes vergleicht und ein zweites Binärsignal mit einem Binärwert "1" ausgibt, wenn die Daten gemäß dem Vergleichsergebnis miteinander identisch sind, während sie das erste Binärsignal mit einem Binärwert "0" ausgibt, wenn sich die Daten gemäß dem Vergleichsergebnis voneinander unterscheiden;
einen dritten Multiplexer (34), der gemäß dem Auswählsignal die Ausgabedaten des dritten Auffangspeichers (36) oder der ersten Vergleichseinrichtung (32) auswählt und das ausgewählte Ergebnis an den dritten Auffangspeicher (36) ausgibt:
einen vierten Multiplexer (35), der gemäß dem Auswählsignal die Ausgabedaten des vierten Auffangspeichers (37) oder der zweiten Vergleicheinrichtung (33) auswählt und das ausgewählte Ergebnis an den vierten Auffangspeicher (37) ausgibt; und
einen fünften Auffangspeicher (36), der Auffangspeicherung der von dem dritten Auffangspeicher (36) ausgegebenen Daten durchführt.

5. Vorrichtung zum Decodieren mit variabler Länge nach einem der Ansprüche 1 bis 4, wobei die Steuersignal-Erzeugungseinrichtung (60) umfasst:
einen RS-Flip-Flop (61), der das Anfangs-Signal von der Zeit-Steuereinrichtung (14) über ein Eingabeende (S) und das erste Binärsignal von dem dritten Auffangspeicher (36) über ein anderes Eingabeende (R) empfängt und die Daten über das Ausgabeende (Q) ausgibt: und
ein UND-Gatter (63), das das Datenanforderungs-Signal von der Decodiereinrichtung (13) logisch mit invertierten Ausgabedaten des fünften Auffangspeichers (38) multipliziert;
ein ODER-Gatter (64), das die von dem RS-Flip-Flop (61) ausgegebenen Daten und die von dem UND-Gatter (63) ausgegebenen Daten logisch summiert und das logisch summierte Ergebnis ausgibt;
einen sechsten Auffangspeicher (65), der Auffangspeichern des Ausgangs von dem ODER-Gatter (64) durchführt und das Auffangspeichern unterzogene Ergebnis als das an dem FIFO-Speicher (11) angelegte Lese-Signal ausgibt; und
einen siebten Auffangspeicher (66), der Auffangspeichern der von dem sechsten Auffangspeicher (65) ausgegebenen Daten durchführt und das Auffangspeichern unterzogene Ergebnis als das Auswählsignal ausgibt.

6. Vorrichtung zum Decodieren mit variabler Länge nach Anspruch 1, wobei die Decodier-Schnittstelleneinrichtung (12) ein Erfassungs-Ergebnissignal ausgibt, wenn der Frame-Anfangscode erfasst wird, und das erzeugte Signal an die Zeit-Steuereinheit (14) ausgibt, und
wobei die Zeit-Steuereinheit (14) das Anfangs-Signal für die erste Operation der Vorrichtung zum Decodieren mit variabler Länge an die Decodier-Schnittstelleneinrichtung (12) ausgibt, ein neues Anfangs-Signal zum Lesen der Daten, die den MMB-Anfangscode enthalten, aus dem FIFO-Speicher (11) auf Basis eines Erfassungs-Ergebnissignals erzeugt, wenn das Erfassungs-Ergebnissignal von der Decodier-Schnittstelleneinrichtung (12) in Reaktion auf das Anfangs-Signal für die erste Operation angelegt wird, und das erzeugte neue Anfangs-Signal an die Decodier-Schnittstelleneinrichtung (12) ausgibt.

## Revendications

1. Appareil de décodage à longueur variable pour faire subir un décodage de longueur variable à des données transmises sous la forme d'un flot binaire de données de trame d'image codées de longueur variable, dans lequel le flot binaire de chaque trame d'image a un format de données constant comprenant des données d'en-tête de trame et des données se rapportant à des masses de macroblocs,
les données d'en-tête de trame comprenant : un code de début de trame (FSC) ; un numéro de trame (FN) ; des informations d'état de tampon (BSI) ; et des bits de remplissage d'en-tête de trame ; et
les masses de données de macroblocs comprenant : plusieurs masses séquentiellement agencées de macroblocs, chacune d'elles comprenant : un code de début de masse de macroblocs (MSC) ; un numéro de masse de macroblocs (MN) ; des Informations de Masse de Macroblocs ; et des bits de remplissage de masse de macrobloc ; et chaque Information de Masse de Macroblocs comprenant des blocs ; et chaque bloc comprenant un code de Fin de Bloc (EOB) ;
dans lequel le code de début de trame (FSC), le numéro de trame (FN), le code de début de masse de macroblocs (MSC) et le numéro de masse de macroblocs (MN) utilisent chacun des codes de longueur fixe et les Informations de Masse de macroblocs de chaque Masse de macrobloc utilisent des codes de longueur variable et les bits de remplissage de masse de macrobloc sont agencés pour assurer que les données de masse de macrobloc soient toujours un multiple de 24 bits, ledit appareil de décodage à longueur variable comprenant :
une mémoire FIFO (11), pour recevoir des données codées de longueur variable et pour sortir séquentiellement lesdites données, un dispositif d'interface de décodage (12) pour recevoir ladite sortie de données en provenance de ladite mémoire FIFO (11), un moyen formant décodeur (13) pour faire subir un décodage de longueur variable aux données codées de longueur variable qui lui sont fournies en provenance du moyen d'interface de décodage (12), et une unité de commande de cadencement (14) pour commander les opérations du dispositif d'interface de décodage (12) et du moyen formant décodeur (13), l'appareil étant **caractérisé en ce que** :
ledit appareil est commandé en se basant sur plusieurs signaux de commande comprenant un signal de lecture (READ) produit à l'intérieur du moyen d'interface de décodage (12), un signal de Demande (RQST) produit par le moyen formant décodeur (13), un signal de début (START) produit par l'unité de commande de cadencement (14), un signal d'initialisation (INIT) produit par l'unité de commande de cadencement (14), un signal d'erreur de fin de bloc (EOB ERROR) produit par le décodeur (13), et un signal désignant la détection d'un Code de Début de Trame (FSC) ou un Code de Début de Masse de Macrobloc (MSC) produit par le moyen d'interface de décodage (12) dans lequel :
ladite mémoire premier entré, premier sorti (FIFO) (11) est agencée pour recevoir et stocker les données codées de longueur variable et pour sortir séquentiellement lesdites données vers le moyen d'interface de décodage (12) dans des blocs de données de 24 bits chaque fois que ledit signal de lecture (READ) est entré dans ce dernier en provenance dudit moyen d'interface de décodage (12) ;
ledit moyen d'interface de décodage (12) est agencé pour :
(i) recevoir des données à 24 bits en provenance de la mémoire FIFO (11) ;
(ii) détecter, s'il est présent dans lesdites données reçues, un code de début de trame (FSC) ou un code de début de Masse de Macrobloc (MSC), et sortir le signal de détection résultant vers l'unité de commande de cadencement (14) ;
(iii) transmettre des données codées de longueur variable au moyen formant décodeur (13) pour décodage ;
(iv) dans lequel la production dudit signal READ est effectuée en réponse soit à la réception du signal de début (START) en provenance de l'unité de commande de cadencement (14), soit à la réception dudit signal de demande de données (RQST) en provenance dudit moyen formant décodeur (13) alors que le signal d'initialisation (INIT) est appliqué ; et
(v) dans lequel la production du signal de lecture (READ) est interrompue si l'un d'un code de début de trame (FSC) ou d'un code de début de MMB (MSC) est détecté dans les données appliquées en provenance de la mémoire FIFO (11), et
(vi) dans lequel les données stockées dans ledit moyen d'interface de décodage sont ensuite fournies au moyen formant décodeur (13) en réponse à la réception d'un signal d'initialisation (INIT) en provenance de l'unité de commande de cadencement (14) ;
ledit moyen formant décodeur (13) est agencé pour produire un signal de demande de données (RQST) chaque fois que 24 bits ont été décodés, ou si le moyen formant décodeur (13) ne peut pas décoder les données parce que le décodeur détermine que les données à décoder comprennent des bits de remplissage, ledit moyen formant décodeur (13) étant en outre conçu pour produire un signal d'erreur d'EOB si les données EOB d'une Masse de Macroblocs ne sont pas correctement détectées dans chaque bloc décodé et pour transmettre ledit signal d'erreur d'EOB à ladite unité de commande de cadencement (14) ;
ladite unité de commande de cadencement (14) est agencée pour produire ledit signal de début (START) et ledit signal d'initialisation (INIT), dans lesquels le signal de début (START) est produit en réponse à la réception dudit signal en provenance du moyen d'interface de décodage (12) désignant la détection d'un Code de Début de Trame (FSC), et le signal d'initialisation (INIT) est produit chaque fois qu'un nouveau code de début de Masse de Macroblocs est détecté par ledit dispositif d'interface de décodage (12), ledit signal d'initialisation (INIT) étant fourni à un intervalle de temps prédéterminé après un signal d'initialisation précédent, ladite unité de commande de cadencement (14) étant en outre agencée en réponse à la réception dudit signal d'erreur d'EOB en provenance du moyen formant décodeur (13) à la fois pour produire un signal de commande pour interrompre le fonctionnement du moyen formant décodeur (12) et pour produire un nouveau signal de début (START) à fournir au moyen d'interface de décodage (13) pour amener le moyen d'interface de décodage à continuellement lire des données stockées à partir de la mémoire FIFO (11) jusqu'à la détection soit d'un Code de Début de trame suivant (FSC) soit d'un Code de Début de Masse de Macrobloc suivant (MSC), moment auquel la synchronisation de l'appareil est rétablie et les opérations de décodage peuvent recommencer.

2. Appareil de décodage à longueur variable selon la revendication 1, dans lequel ledit moyen d'interface de décodage (12) comprend : une partie de verrouillage de données (20) dont la borne d'entrée de données est reliée à une borne de sortie de données de ladite mémoire FIFO (11), et dont la borne de sortie de données est reliée audit moyen de décodage (13), pour verrouiller la sortie de données en provenance de ladite mémoire FIFO (11) à chaque signal de lecture dans l'ordre d'entrée selon un signal de sélection ; un détecteur (30) pour recevoir les données verrouillées vers ladite partie de verrouillage de données (20) et les données sorties en provenance de ladite mémoire FIFO (11), détecter un signal entre le signal de début de trame (FSC) et le signal de début de MMB (MSC), verrouiller un premier signal binaire qui est produit pour varier sa valeur selon un résultat de détection, et effacer le premier signal binaire verrouillé si un signal entre le signal de début et le signal d'initialisation est entré en provenance de ladite unité de commande de cadencement (14) ; et un générateur de signal de commande (60) pour produire le signal de lecture dont la valeur se situe entre la première valeur binaire pour valider la lecture des données à partir de ladite mémoire FIFO (11) et une deuxième valeur binaire pour invalider la lecture des données à partir de ladite mémoire FIFO (11), et le signal de sélection dont la valeur se situe entre une troisième valeur binaire pour à nouveau verrouiller les données fournies en provenance de ladite mémoire FIFO (11) et une quatrième valeur binaire pour maintenir les données déjà verrouillées comme elles sont.

3. Appareil de décodage à longueur variable selon la revendication 2, dans lequel ladite partie de verrouillage de données (20) comprend :
des premier et deuxième circuits de verrouillage (22, 24) pour séquentiellement verrouiller les données sorties en provenance de ladite mémoire FIFO (11) et pour sortir les données verrouillées vers ledit moyen de décodage (13) ;
un premier multiplexeur (21) pour recevoir les données de sortie en provenance de ladite mémoire FIFO (11) et dudit premier circuit de verrouillage (22) et pour sortir les données reçues vers ledit premier circuit de verrouillage (22) selon une valeur binaire du signal de sélection ; et
un deuxième multiplexeur (23) pour recevoir les données de sortie en provenance desdits premier et deuxième circuits de verrouillage (22, 24) et pour sortir les données reçues vers ledit deuxième circuit de verrouillage (24) selon une valeur binaire du signal de sélection.

4. Appareil de décodage à longueur variable selon la revendication 3, dans lequel ledit détecteur (30) comprend :
des troisième et quatrième circuits de verrouillage (36, 37) dont les valeurs de sortie sont effacées à zéro respectivement par le signal de début et le signal d'initialisation en provenance de ladite unité de commande de cadencement (14) ;
un premier comparateur (32) pour comparer les données de sortie en provenance dudit premier circuit de verrouillage (36) au code de début de MMB fixé de façon prédéterminée, et pour sortir un premier signal binaire ayant une valeur binaire "1" si les données sont identiques les unes aux autres selon le résultat de comparaison, tandis qu'il sort le premier signal binaire ayant une valeur binaire "0" si les données diffèrent les unes des autres selon le résultat de comparaison ;
un second comparateur (33) pour comparer les données entrées dans ledit premier multiplexeur (21) à une partie du code de début de trame fixé de façon prédéterminée, et pour sortir un second signal binaire ayant une valeur binaire "1" si les données sont identiques les unes aux autres selon le résultat de comparaison, tandis qu'il sort le premier signal binaire ayant une valeur binaire "0" si les données diffèrent les unes des autres selon le résultat de comparaison ;
un troisième multiplexeur (34) pour sélectionner entre les données de sortie dudit troisième circuit de verrouillage (36) et dudit premier comparateur (32) selon le signal de sélection et pour sortir le résultat sélectionné vers ledit troisième circuit de verrouillage (36) ;
un quatrième multiplexeur (35) pour sélectionner entre les données de sortie dudit quatrième circuit de verrouillage (37) et dudit second comparateur (33) selon le signal de sélection et pour sortir le résultat sélectionné vers ledit quatrième circuit de verrouillage (37) ; et
un cinquième circuit de verrouillage (38) pour verrouiller les données de sortie en provenance dudit troisième circuit de verrouillage (36).

5. Appareil de décodage à longueur variable selon l'une quelconque des revendications 1 à 4, dans lequel ledit générateur de signal de commande (60) comprend :
une bascule RS (61) pour recevoir le signal de début en provenance de ladite unité de commande de cadencement (14) par l'intermédiaire d'une borne d'entrée (S) et le premier signal binaire en provenance dudit troisième circuit de verrouillage (36) par l'intermédiaire d'une autre borne d'entrée (R), et pour sortir les données par l'intermédiaire de la borne de sortie (Q) ;
une porte ET (63) pour multiplier de façon logique le signal de demande de données en provenance dudit moyen de décodage (13) par des données de sortie inversées dudit cinquième circuit de verrouillage (38) ;
une porte OU (64) pour additionner de façon logique les données de sortie en provenance de ladite bascule RS (61) et les données de sortie en provenance de ladite porte ET (63) et pour sortir le résultat additionné de façon logique ;
un sixième circuit de verrouillage (65) pour verrouiller la sortie en provenance de ladite porte OU (64) et pour sortir le résultat verrouillé en tant que signal de lecture appliqué à ladite mémoire FIFO (11) ; et
un septième circuit de verrouillage (66) pour verrouiller les données de sortie en provenance dudit sixième circuit de verrouillage (65) et pour sortir le résultat verrouillé en tant que signal de sélection.

6. Appareil de décodage à longueur variable selon la revendication 1, dans lequel ledit moyen d'interface de décodage (12) produit un signal de détection résultant si le code de début de trame est détecté et pour sortir le signal produit vers ladite unité de commande de cadencement (14), et
dans lequel ladite unité de commande de cadencement (14) sort le signal de début pour la première opération dudit appareil de décodage à longueur variable vers ledit moyen d'interface de décodage (12), produit un nouveau signal de début pour lire les données contenant le code de début de MMB en provenance de ladite mémoire FIFO (11) en se basant sur un signal de détection résultant si le signal de détection résultant est appliqué en provenance dudit moyen d'interface de décodage (12) en réponse au signal de début pour la première opération, et sort le nouveau signal de début produit vers ledit moyen d'interface de décodage (12).
